# EUROPEAN PATENT APPLICATION

(11) **EP 4 432 349 A1**
(43) Date of publication of application: **18.09.2024**
(21) Application number: 22892131.8
(22) Date of filing: 12.11.2022
(51) Int. Cl.: H01L 23/498

(54) **SEMICONDUCTOR POWER MODULE, MOTOR CONTROLLER, AND VEHICLE**

(30) Priority: 12.11.2021 CN 202111342962
(71) Applicant: BYD Semiconductor Company Limited, Shenzhen, 518119 (CN)
(72) Inventor: ZHOU, Yuqi, Shenzhen, Guangdong 518119 (CN); LIU, Chunjiang, Shenzhen, Guangdong 518119 (CN); ZHANG, Jianli, Shenzhen, Guangdong 518119 (CN)
(74) Representative: Gulde & Partner
(86) International application number: PCT/CN2022/131570
(87) International publication number: WO 2023/083338

(57) **Abstract**

A semiconductor power module, a motor controller, and a vehicle are disclosed. The semiconductor power module includes: a substrate that has a first direction and a second direction that are orthogonal to each other; a first conductive region, a second conductive region, a third conductive region and a fourth conductive disposed on the substrate that are spaced apart from each other and that are arranged in sequence along the first direction of the substrate; a first power chip and a second power chip. Each of the first conductive region, the second conductive region, the third conductive region and the fourth conductive region extends along the second direction of the substrate, the first conductive region and the third conductive region are configured to receive a direct current signal, and the fourth conductive region is configured to transmit an alternating current signal. The first power chip is electrically connected to each of the first conductive region and the second conductive region, the second power chip is electrically connected to each of the second conductive region, the third conductive region and the fourth conductive region.

## Description

### CROSS-REFERENCE TO RELATED APPLICATIONS

The present application claims the priority to the Chinese patent application No. 202111342962.1 entitled "SEMICONDUCTOR POWER MODULE, MOTOR CONTROLLER, AND VEHICLE" and filed with the China National Intellectual Property Administration on November 12, 2021, the entirety of which is incorporated herein by reference.

### TECHNICAL FIELD

The present disclosure relates to the field of vehicle technology, more particularly, to a semiconductor power module, motor controller, and vehicle.

### BACKGROUND

Semiconductor power modules are widely used in industry. A semiconductor power module is usually used in an inverter to convert alternating current to direct current or convert direct current to alternating current.

The semiconductor power module has the advantages of a high integration degree and a small volume. However, in the inversion process, a stray inductance of the circuit generates a too large voltage during the switching of the semiconductor chip and generates electromagnetic interference due to damping oscillations, thereby increasing the switching loss. Meanwhile, a large output current needs multiple chips to be connected in parallel, but it will cause the chips to occupy a large position and will cause the inductance to increase.

### SUMMARY

The present disclosure aims to solve at least one of the technical problems existing in the prior art. Therefore, a first purpose of the present disclosure is to propose a semiconductor power module which can reduce the stray inductance of the entire module and improve the heat dissipation of the module.

A second purpose of the present disclosure is to propose a motor controller.

A third purpose of the present disclosure is to propose a vehicle.

In order to solve the above problems, an embodiment in a first aspect of the present disclosure provides a semiconductor power module. The semiconductor power module includes: a substrate having a first direction and a second direction that are orthogonal to each other; a first conductive region, a second conductive region, a third conductive region and a fourth conductive disposed on the substrate that are spaced apart from each other and that are arranged in sequence along the first direction of the substrate, wherein each of the first conductive region, the second conductive region, the third conductive region and the fourth conductive region extends along the second direction of the substrate, the first conductive region and the third conductive region are configured to transmit a direct current signal, and the fourth conductive region is configured to transmit an alternating current signal; and at least one first power chip and at least one second power chip, the first power chip is electrically connected to each of the first conductive region and the second conductive region, the second power chip is electrically connected to each of the second conductive region, the third conductive region and the fourth conductive region.

According to the semiconductor power module of the present disclosure, based on the layout design of the first conductive region, the second conductive region, the third conductive region and the fourth conductive region, the first power chip of the second conductive region is connected to the first conductive region and the fourth conductive region, and the second power chip of the third conductive region is connected to the fourth conductive region. In this way, the circuit can form a first bridge arm and a second bridge arm of a half-bridge circuit after the circuit is connected, and mutual inductance is formed between the first bridge arm and the second bridge arm to thereby reduce the parasitic inductance of the entire module. In addition, based on the layout design of the first conductive region, the second conductive region, the third conductive region and the fourth conductive region, some first power chips and some second power chips are uniformly arranged in the four conductive regions, with good heat-dissipation performance, simple structure, and a high integration degree.

In some embodiments, the first conductive region and the third conductive region are configured to receive the direct current signal, and the fourth conductive region is configured to output the alternating current signal.

In some embodiments, the at least one first power chip 6 forms a first bridge arm of the half-bridge circuit with the first conductive region, the second conductive region and the fourth conductive region. The at least one second power chip 7 forms a second bridge arm of the half-bridge circuit with the third conductive region and the fourth conductive region.

In some embodiments, the first power chip and the second power chip are arranged along the first direction.

In some embodiments, a plurality of first power chips are included, the plurality of the first power chips are arranged along the second direction, and two first power chips that are disposed adjacent to each other are staggered in the first direction. A plurality of second power chips are included, the plurality of the second power chips are arranged along the second direction, and two second power chips that are disposed adjacent to each other are staggered in the first direction.

In some embodiments, the first power chip is provided in the second conductive region, and the second power chip is provided in the third conductive region.

In some embodiments, the first conductive region includes: a first main conductive portion extending in the second direction and configured to receive the direct current signal; and a plurality of first conductive branches arranged along the second direction. The first conductive branch is connected with the first main conductive portion and extends towards the second conductive region in the first direction. A plurality of first power chips are included, at least one of the plurality of the first power chips is connected to the first main conductive portion of the first conductive region, and at least one of the plurality of the first power chips is connected to the first conductive branch of the first conductive region.

In some embodiments, the second conductive region includes: a second main conductive portion extending in the second direction; a plurality of second conductive branches arranged along the second direction, wherein the second conductive branch is connected with the second main conductive portion and extends towards the first conductive region in the first direction; and a plurality of third conductive branches arranged along the second direction, wherein the third conductive branch is connected with the second main conductive portion and extends towards the third conductive region in the first direction. At least one of the plurality of the first power chips is connected to the second main conductive portion of the second conductive region, and at least one of the plurality of the first power chips is connected to the second conductive branch of the second conductive region. A plurality of second power chips are included, at least one of the plurality of the second power chips is connected to the second main conductive portion of the second conductive region, and at least one of the plurality of the second power chips is connected to the third conductive branch of the second conductive region.

In some embodiments, the first conductive branch and the second conductive branch are arranged alternately along the second direction. Each of the plurality of first conductive branches is connected to a corresponding position of the second main conductive portion via the first power chip, and each of the plurality of second conductive branches is connected to a corresponding position of the first main conductive portion via the first power chip.

In some embodiments, the third conductive region includes: a third main conductive portion extending in the second direction and configured to receive the direct current signal; a plurality of fourth conductive branches arranged in the second direction, wherein the fourth conductive branch is connected with the third main conductive portion and extends towards the second conductive region in the first direction; and a plurality of fifth conductive branches arranged in the second direction, wherein the fifth conductive branch is connected with the third main conductive portion and extends towards the fourth conductive region in the first direction. At least one of the plurality of the second power chips is connected to the fourth conductive branch of the third conductive region, and at least one of the plurality of the second power chips is connected to the fifth conductive branch of the third conductive region.

In some embodiments, the third conductive branch and the fourth conductive branch are arranged alternately along the second direction. Each of the plurality of fourth conductive branches is connected to a corresponding position of the second main conductive portion via the second power chip, and each of the plurality of third conductive branch is connected to a corresponding position of the fifth conductive branch via the second power chip.

In some embodiments, the fourth conductive region includes: a fourth main conductive portion extending in the second direction and configured to output the alternating current signal; and a plurality of sixth conductive branches arranged along the second direction, wherein the sixth conductive branch is connected with the fourth main conductive portion and extends towards the third conductive region. At least one of the plurality of the second power chips is connected to the fourth main conductive portion of the fourth conductive region, and at least one of the plurality of the second power chips is connected to the sixth conductive branch of the fourth conductive region.

In some embodiments, the fifth conductive branch and the sixth conductive branch are arranged alternately along the second direction. Each of the plurality of sixth conductive branches is connected to a corresponding position of the fourth conductive branch via the second power chip, and each of the plurality of fifth conductive branches is connected to a corresponding position of the fourth main conductive portion via the second power chip.

In some embodiments, at least one of the plurality of the first power chips is provided in the second conductive branch and is connected to the first main conductive portion, and at least one of the plurality of the first power chips is provided in the second main conductive portion and is connected to the first conductive branch.

In some embodiments, at least one of the plurality of the second power chips is provided in the fourth conductive branch and is connected to each of the second main conductive portion and the sixth conductive branch, and at least one of the plurality of the second power chips is provided in the fifth conductive branch and is connected to each of the third conductive branch and the fourth main conductive portion.

In some embodiments, the semiconductor power module further includes a fifth conductive region and a sixth conductive region that are respectively connected to both ends of the third conductive region. The fifth conductive region and the sixth conductive region are respectively located on both sides of the first conductive region in the second direction and on both sides of the second conductive region in the second direction, and the fifth conductive region and the sixth conductive region are respectively spaced apart from the first conductive region and the second conductive region. The third conductive region is configured to receive the direct current signal via the fifth conductive region and the sixth conductive region.

In some embodiments, the first conductive region has a first direct current connection point for receiving the direct current signal on a side of the first conductive region that faces away from the second conductive region, the fifth conductive region has a second direct current connection point for receiving the direct current signal on an end of the fifth conductive region that is further away from the third conductive region, the sixth conductive region has a third direct current connection point for receiving the direct current signal on an end of the sixth conductive region that is further away from the third conductive region, and the fourth conductive region has an alternating current connection point on a side of the fourth conductive region that faces away from the third conductive region.

The first direct current connection point, the second direct current connection point and the third direct current connection point are disposed on one side of the substrate in the first direction and are arranged in the second direction. The first direct current connection point is disposed between the second direct current connection point and the third direct current connection point. A polarity of the direct current signal connected to the second direct current connection point is the same as a polarity of the direct current signal connected to the third direct current connection point and is opposite to a polarity of the direct current signal connected to the first direct current connection point, and the alternating current connection point is located on another side of the substrate in the first direction.

In some embodiments, the semiconductor power module further includes: a seventh conductive region located on a side of the first conductive region that faces away from the second conductive region. The seventh conductive region is spaced apart from the first conductive region. Both ends of the seventh conductive region are connected to the fifth conductive region and the sixth conductive region respectively. The third conductive region, the fifth conductive region, the sixth conductive region, and the seventh conductive region collectively surrounds the first conductive region and the second conductive region.

In some embodiments, the semiconductor power module further includes: a first small signal conductive region provided in the substrate; and a first small signal input substrate provided in the second conductive region. The first small signal input substrate is connected to each of the first small signal conductive region and the first power chip to transmit a gate signal to the first power chip.

In some embodiments, the semiconductor power module further includes: a second small signal conductive region provided in the substrate; and a second small signal input substrate provided in the third conductive region. The second small signal input substrate is connected to each of the second small signal conductive region and the second power chip to transmit a gate signal to the second power chip.

In some embodiments, the semiconductor power module further includes: an insulating cover mounted on the substrate and covering the first conductive region, the second conductive region, the third conductive region, the fourth conductive region, the at least one first power chip, and the at least one second power chip.

A motor controller is provided according to an embodiment in a second aspect of the present disclosure. The motor controller includes: a heat-dissipating base plate and a cooling liquid channel, the heat-dissipating base plate being mounted to the cooling liquid channel; and the semiconductor power module according to the above embodiment, the semiconductor power module being disposed on the heat-dissipating base plate.

According to the motor controller of the present disclosure, by adopting the semiconductor power module that is provided in any of the above embodiments and that is disposed on the heat-dissipation base plate, the stray inductance in the circuit can be effectively reduced and the heat dissipation is good.

A vehicle is provided according to an embodiment in a third aspect of the present disclosure. The vehicle includes: a motor; and the motor controller according to the above embodiment. The motor controller is connected to the motor.

In the vehicle of the present disclosure, by by adopting the motor controller that is provided in any of the above embodiments, the inductance can be reduced and the heat dissipation can be improved.

The additional aspects and advantages of this disclosure will be provided in the following description, which will become apparent from the following description, or will be learned through the practice of this application.

### BRIEF DESCRIPTION OF DRAWINGS

The above and/or additional aspects and advantages of the present disclosure will become apparent and easy to understand from the description of embodiments in conjunction with the accompanying drawings, in which:
FIG. 1 is a schematic diagram of a semiconductor power module according to an embodiment of the present disclosure;
FIG. 2 is a schematic diagram showing current flow direction of a semiconductor power module according to an embodiment of the present disclosure;
FIG. 3 is a schematic diagram of a semiconductor power module according to another embodiment of the present disclosure;
FIG. 4 is a top view of a semiconductor power module according to an embodiment of the present disclosure;
FIG. 5 is a schematic diagram of a plastic packaged semiconductor power module according to an embodiment of the present disclosure;
FIG. 6 is a schematic diagram showing a perspective structure of a plastic packaged semiconductor power module according to an embodiment of the present disclosure;
FIG. 7 is a side view of a semiconductor power module according to an embodiment of the present disclosure;
FIG. 8 is a schematic view of a semiconductor power module according to another embodiment of the present disclosure;
FIG. 9 is a schematic view showing a structure of a motor controller according to an embodiment of the present disclosure;
FIG. 10 is a block diagram showing a structure of a vehicle according to an embodiment of the present disclosure.

### Reference numerals:

Vehicle 100;
Semiconductor power module 10; Motor controller 20;
Substrate 1; First conductive region 2; Second conductive region 3; Third conductive region 4; Fourth conductive region 5; First direct current connection point 11; Second direct current connection point 12; Third direct current connection point 13; Alternating current connection point 14; First power chip 6; Second power chip 7; First main conductive portion 21; First conductive branch 22; Second main conductive portion 31; Second conductive branch 32; Third conductive branch 33; Third main conductive portion 43; Fourth conductive branch 44; Fifth conductive branch 45; Fourth main conductive portion 51; Sixth conductive branch 52; First small signal conductive region 8; Second small signal conductive region 9; First small signal input substrate 34; Second small signal input substrate 46; Fifth conductive region 101; Sixth conductive region 102; Seventh conductive region 103; Cooling liquid liquid channel 16; Heat-dissipating base plate 16; Motor 17.

### DESCRIPTION OF EMBODIMENTS

The following is a detailed description of embodiments of the present disclosure, and the embodiments described with reference to the accompanying drawings are exemplary. The embodiments of the present disclosure will be described in details.

In order to solve the above problems, the first aspect of the present disclosure proposes a semiconductor power module which can reduce the stray inductance of the entire module and improve the heat-dissipation of the module.

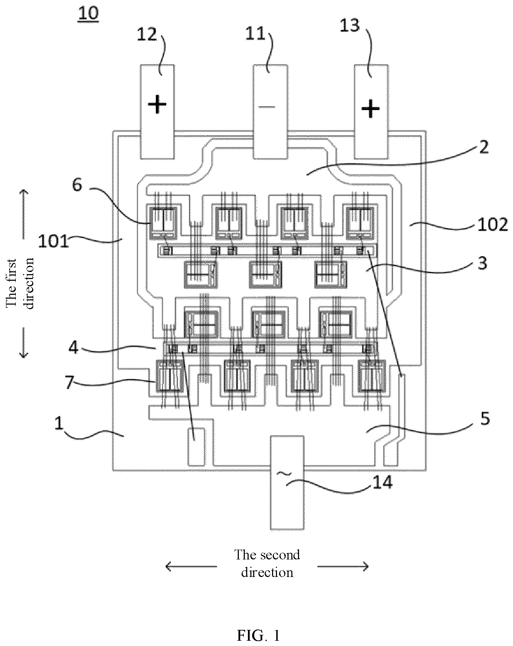

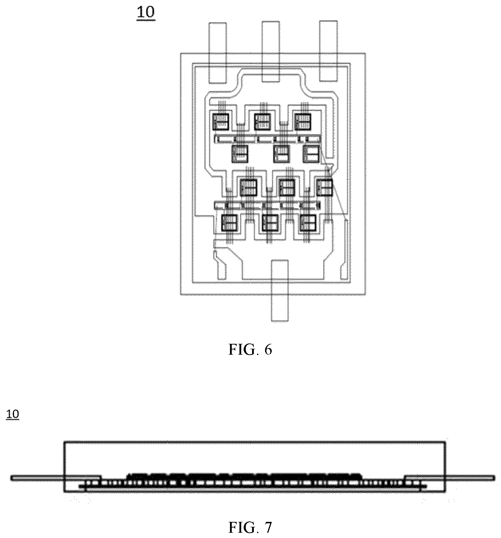

The semiconductor power module according to embodiments of the present disclosure will be described below with reference to FIG. 1 to FIG. 8.

As shown in FIG. 1, the semiconductor power module 10 includes a substrate 1 and a first conductive region 2, a second conductive region 3, a third conductive region 4 and a fourth conductive 5, a plurality of first power chips 6 and a plurality of second power chips 7. The first conductive region 2, the second conductive region 3, the third conductive region 4 and the fourth conductive 5 are disposed on the substrate 1 and are arranged in sequence along the first direction of the substrate 1.

In the embodiment, the substrate 1 may be an insulating substrate with high insulating strength, good thermal conductivity, and stable chemical properties, such as an insulating ceramic, for example, Al₂O₃, AlN, or Si₃N₄, etc. Thus, the setup of the insulating substrate 1 can not only block the electrical connection between a circuit and an external device, such as a heatsink, and play an insulating role, but also provide a heat-dissipation channel for the loss caused by the subsequent power chip operation, and improve the overall heat-dissipation of the module.

Wherein the substrate 1 has a first direction and a second direction that are orthogonal to each other, that is, if the first direction is a length direction of the substrate 1, the second direction is a width direction of the substrate 1; or if the first direction is the width direction of the substrate 1, the second direction is the length direction of the substrate 1. In this regard, the first direction and the second direction can be set according to the actual situation, such as the shape of the substrate 1, and there is no limitation thereon.

In addition, as shown in FIG. 1, the first conductive region 2, the second conductive region 3, the third conductive region 4, and the fourth conductive region 5 are spaced apart from each other to avoid short-circuiting caused by overlapping of these conductive regions. Each of the first conductive region 2, the second conductive region 3, the third conductive region 4, and the fourth conductive region 5 extends along the second direction of the substrate 1. The first conductive region 2 and the third conductive region 4 are configured to transmit a direct current signal, and the fourth conductive region 5 is configured to transmit an alternating current signal, so as to realize the electrical energy conversion function of the semiconductor power module 10. Optionally, in order to form a better circuit structure so as to suppress inductance, the fourth conductive region 5 may be in an electrical connection with the second conductive region 3 by means of leads.

A copper layer is attached to each of both sides of the insulating substrate 1 by printing process, the copper layer on one side of the substrate 1 is etched to form the four conductive regions described above, so that a three-layer substrate can be formed between the insulating substrate 1 and the these conductive regions, that is, copper layer-ceramic layer-copper layer. Therefor, a whole sheet of bare copper is at the back side of the substrate, that is, the side of the substrate away from these conductive regions, an etched copper layer is at the front side of the substrate, that is, the side of the substrate where these conductive regions are located, and the etched copper layer forms a conductive channel which forms a half-bridge circuit of the semiconductor power module 10 after being electrically connected.

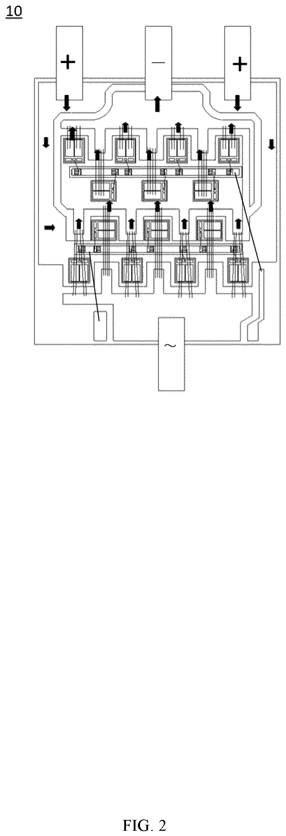

Specifically, referring to FIG. 1 and FIG. 2, the first power chip 6 is electrically connected to each of the first conductive region 2 and the second conductive region 3, and the second power chip 7 is electrically connected to each of the second conductive region 3, the third conductive region 4, and the fourth conductive region 5. The second conductive region 3 and the fourth conductive region 5 are electrically connected through a lead. This enables the first power chip 6 to form a circuit connection relationship with the fourth conductive region 5 via the lead. When a plurality of first power chips 6 and a plurality of first power chips 7 are arranged, the first power chips 6, the first conductive region, the second conductive region and the fourth conductive region can form a first bridge arm of the half-bridge circuit, such as an upper bridge arm of the half-bridge circuit. Another portion of the second power chips 7, the third conductive region and the fourth conductive region can form a second bridge arm of the half-bridge circuit, such as a lower bridge arm of the half-bridge circuit. Thus, when the semiconductor power module 10 is connected, mutual inductance is formed between the first bridge arm and the second bridge arm, which serves to counteract the inductance, thereby reducing the parasitic inductance of the entire module. At the same time, because the first conductive region 2, the second conductive region 3, the third conductive region 4, and the fourth conductive region 5 that are arranged in sequence along the first direction of the substrate 1, it is also convenient to arrange the first power chips 6 and the second power chips 7 uniformly in the four conductive regions, avoiding the situation where the power chips are arranged in a compact manner, thereby facilitating the reduction of the inductance while increasing heat-dissipation and enhancing the current output capability.

In an embodiment, the power chip may use silicon or silicon carbide or other semiconductor materials as the substrate. For example, the power chip may use silicon carbide Metal-Oxide-Semiconductor Field-Effect Transistor (MOSFET), or may use a device obtained by cooperation of Insulated Gate Bipolar Transistor (IGBT) and Fast Recovery Diode (FRD). The power chip is not limited to any of the examples.

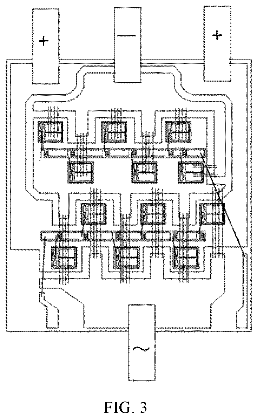

Under the premise of realizing an electrical connection between the power chip and the different conductive regions, there is no limitation on the arrangement of the power chip and the different conductive regions. For example, the power chip can be fixed in a corresponding conductive region by welding attachment or bonding attachment, or it can be installed in a suspended manner at the corresponding conductive region. In addition, each power chip can be electrically connected between different conductive regions via leads. For example, as shown in FIG. 3, the first power chip 6 of the second conductive region 3 is connected to the first conductive region 2 via a lead; Alternatively, each power chip can be electrically connected between different conductive regions via copper sheet bonding, there is no limitation on this.

The number of the first power chip(s) 6 and the number of the second power chip(s) 7 can be set according to the actual needs, there is no limitation on this. For example, in the semiconductor power module 10 shown in FIG. 1, the number of the first power chips 6 is 7 and the number of the second power chips 7 is 7. Considering the need to output a large current, the number of power chips can be increased. As shown in FIG. 3, in another embodiment, in the semiconductor power module 10, the number of first power chips 6 is 6 and the number of second power chips 7 is 6. It should be noted that the total number of the first power chip(s) 6 is the same as the total number of the second power chip(s).

In an embodiment, the first conductive region 2, the second conductive region 3, the third conductive region 4 and the fourth conductive region 5 each can be designed as a conductive region having a regular shape, such as a square conductive region. Alternatively, the first conductive region 2, the second conductive region 3, the third conductive region 4 and the fourth conductive region 5 each can be designed as a conductive region having an irregular shape. For example, each two of these conductive regions are staggered or match each other, and the present application is not limited thereto.

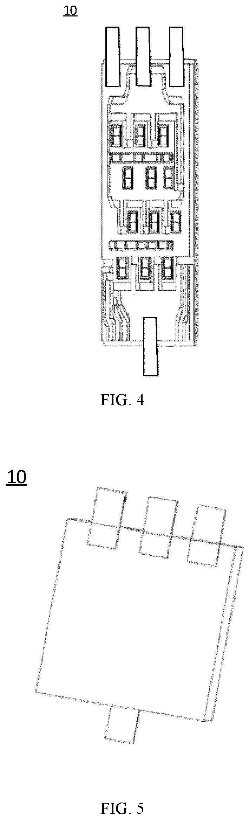

In an embodiment, the semiconductor power module 10 needs to be packaged in practical application. For example, the semiconductor power module 10 can be packaged by the plastic package method. That is, a semi-finished product of the semiconductor power module 10 can be packaged by injection moulding. Specifically, all the structures in the semiconductor power module 10 shown in FIG. 4 are mounted in a frame and are subject to plastic packaging to form a plastic packaged body module, such as the plastic packaged semiconductor power module 10 as shown in FIG. 5, FIG. 6 and FIG. 7. Alternatively, a potting method may be used, that is, a semi-finished product of the semiconductor power module 10 is subject to a potting forming process in which an insulating material such as silicone gel is used. Specifically, all of the structures in the semiconductor power module 10 shown in FIG. 4 are mounted in a frame, and the silicone gel is filled into the frame to form a potted module. It should be noted that the semiconductor power module 10 is a half-bridge power module which can be applied to a half-bridge circuit or a three-phase full-bridge circuit. Here, for the plastic package method, a single semiconductor power module 10 forms one plastic package body, that is, one half-bridge circuit forms one plastic package body. For the potting method, a single semiconductor power module 10 can forms a potted body, that is, one half-bridge circuit forms a potted body, or three semiconductor power modules 10 can form one potted body, that is, a three-phase full-bridge circuit composed of three half-bridge circuits forms a potted body.

According to the semiconductor power module 10 of the present disclosure, based on the layout design of the first conductive region 2, the second conductive region 3, the third conductive region 4 and the fourth conductive region 5, the first power chip 6 provided in the second conductive region 3 is connected to the first conductive region 2, and the second power chip 7 provided in the third conductive region 4 is connected to the second conductive region 3 and the fourth conductive region 5, so as to form a first bridge arm and a second bridge arm of the half-bridge circuit after the circuit is connected. Mutual inductance is formed between the first bridge arm and the second bridge arm to thereby reduce the parasitic inductance of the entire module. In addition, based on the layout design of the first conductive region 2, the second conductive region 3, the third conductive region 4 and the fourth conductive region 5, some first power chips 6 and some second power chips 7 are uniformly arranged in these four conductive regions, with good heat-dissipation performance, simple structure, and a high integration degree. Furthermore, the use of the insulating substrate 1 can also provide a heat-dissipation channel for the loss caused by the power chip operation, and improve the overall heat-dissipation of the module.

In some embodiments, when the semiconductor power module is used as an electronic controller, the first conductive region 2 and the third conductive region 4 are configured to receive a direct current signal, and the fourth conductive region 5 is configured to output an alternating current signal. In this way, the semiconductor power module can effectively realize the control of an electronic device connected thereto.

In some other embodiments, when the semiconductor power module is used as a charger, the fourth conductive region 5 is configured to receive an alternating current signal, and the first conductive region 2 and the third conductive region 4 are configured to output a direct current signal.

In some embodiments, the first power chip 6 and the second power chip 7 are arranged along the first direction. For example, as shown in FIG. 1, along the first direction, seven first power chips 6 are provided in the second conductive region 3 and are electrically connected to the first conductive region 2, and seven second power chips 7 are provided in the third conductive region 4 and are electrically connected to the second conductive region 3 and the fourth conductive region 5. Therefore, the first power chips 6 and the second power chips 7 are arranged in a spaced-apart manner in the first direction. In this way, the first power chips 6 and the second power chips 7 can be connected in series in the first direction to form a half-bridge circuit of the semiconductor power module 10, so as to reduce the parasitic inductance of the entire module, and, at the same time, avoid the problem of heat increase due to the compact layout of the power chips.

In some embodiments, as shown in FIG. 1, a plurality of first power chips are included, the plurality of the first power chips are arranged along the second direction, and two first power chips that are disposed adjacent to each other are staggered in the first direction. A plurality of second power chips 7 are included, the plurality of the second power chips 7 are arranged along the second direction, and two second power chips 7 that are disposed adjacent to each other are staggered in the first direction. Thus, by staggering the power chips arranged along the second direction, the heat-dissipation of the module can be further improved while reducing the inductance.

In some embodiments, as shown in FIG. 1, when the direct current signal received by the first conductive region 2 is a cathodic electrical signal and the direct current signal received by the third conductive region 4 is an anodic electrical signal, the first power chip 6 is provided in the second conductive region 3 and the second power chip 7 is provided in the third conductive region 4. In this way, under the premise of realizing the electrical energy conversion function of the semiconductor power module 10, the first power chip 6 and the second power chip 7 can be connected in series to form a half-bridge circuit of the semiconductor power module 10, so as to reduce the parasitic inductance of the entire module.

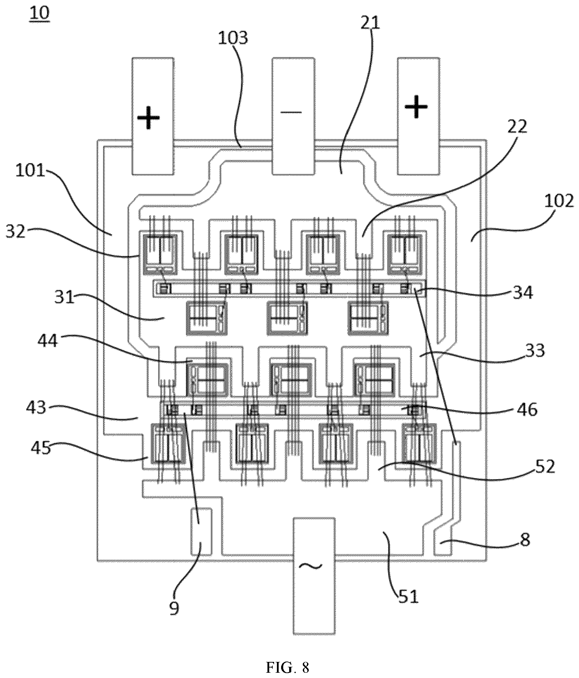

In some embodiments, as shown in FIG. 8, the first conductive region 2 includes a first main conductive portion 21 and a plurality of first conductive branches 22 arranged along the second direction. The first main conductive portion 21 extends in the second direction and is configured to receive a direct current signal. The first conductive branch 22 is connected to the first main conductive portion 21 and extends towards the second conductive region 3 in the first direction. A plurality of first power chips 6 are included, at least one of the plurality of the first power chips 6 is connected to the first main conductive portion 21 of the first conductive region 2, and at least one of the plurality of the first power chip 6 is connected to the first conductive branch 22 of the first conductive region 2. In this way, mutual inductance can be formed within the semiconductor power module 10 when it is working, so as to effectively reduce the parasitic inductance of the entire module , and the internal structural layout of the semiconductor power module 10 can be optimized so as to be conducive to improving the integration degree of the entire module. In addition, based on the layout of the first main conductive portion 21 and the first conductive branches 22, the plurality of first power chips 6 can be efficiently and uniformly arranged, instead of being connected with a same conductive portion of the conductive region, thereby avoiding the problem of increased heat due to the compact layout of the power chips and improving the heat dissipation of the module. In some embodiments, as shown in FIG. 8, the second conductive region 3 includes a second main conductive portion 31, a plurality of second conductive branches 32 arranged along the second direction, and a plurality of third conductive branches 33 arranged along the second direction. The second main conductive portion 31 extends in the second direction, the second conductive branch 32 is connected with the second main conductive portion 31 and extends towards the first conductive region 2 in the first direction. The third conductive branch 33 is connected with the second main conductive portion 31 and extends towards the third conductive region 4 in the first direction. At least one of the plurality of the first power chips 6 is connected to the second main conductive portion 31 of the second conductive region 3, at least one of the plurality of the first power chip 6 is connected to the second conductive branch 32 of the second conductive region 3. A plurality of the second power chips 7 are included, at least one of the plurality of the second power chip 7 is connected to the second main conductive portion 31 of the second conductive region 3, at least one of the plurality of the second power chip 7 is connected to the third conductive branch 33 of the second conductive region 3. In this way, mutual inductance can be formed within the semiconductor power module 10 when it is working so as to effectively reduce the parasitic inductance of the entire module, the internal structural layout of the semiconductor power module 10 can be optimized so as to be conducive to improving the integration degree of the entire module. In addition, based on the layout of the second main conductive portion 31, the second conductive branch 32 and the third conductive branch 33, the plurality of first power chips 6 and the plurality of second power chips 7 can be efficiently and uniformly arranged, instead of being connected with a same conductive portion of the conductive region, thereby avoiding the problem of increased heat due to the compact layout of the power chips and improving the heat dissipation of the module.

In some embodiments, the first conductive branch 22 and the second conductive branch 32 are arranged alternately along the second direction. Each of the plurality of first conductive branches 22 is connected to a corresponding position of the second main conductive portion 31 via a first power chip 6, and each of the plurality of second conductive branches 32 is connected to a corresponding position of the first main conductive portion 31 via a first power chip 6. Thus, the first conducting branch 22 and the second conducting branch 32 are arranged in the alternating arrangement, so that the two adjacent first power chips 6 can be staggered in the first direction, so as to improve the heat-dissipation of the module.

In addition, based on the layout of the first conductive region 2 and the second conductive region 3 described above, any number of first conductive branches 22 can be provided, as well as the second conductive branches 32 that matches the any number of first conductive branches 22 can be provided. Therefore, when the first power chips 6 are provided in the first conductive region 2 and the second conductive region 3, both an even number of power chips or an odd number of power chips can be suitably arranged, and are no longer limited to be arranged in a symmetrical manner. In this way, the first power chips 6 can be placed in a diversified manner, the cost is low and the structure is simple.

In some embodiments, as shown in FIG. 8, the third conductive region 4 includes a third main conductive portion 43, a plurality of fourth conductive branches 44 arranged in the second direction, and a plurality of fifth conductive branches 45 arranged in the second direction.

The third main conductive portion 43 extends in the second direction and is configured to receive a direct current signal. The fourth conductive branch 44 is connected with the third main conductive portion 43 and extends towards the second conductive region 3 in the first direction. The fifth conductive branch 45 is connected with the third main power conductive portion 43 and extends towards the fourth conductive region 5 in the first direction. At least one of the plurality of the second power chips 7 is connected to the fourth conductive branch 44 of the third conductive region 4, and at least one of the plurality of the second power chips 7 is connected to the fifth conductive branch 45 of the third conductive region 4. Therefore, mutual inductance be formed within the semiconductor power module 10 when it is working so as to effectively reduce the parasitic inductance of the entire module, and the internal structural layout of the semiconductor power module 10 can be optimized so as to be conducive to improving the integration degree of the entire module. In addition, based on the layout of the fourth conductive branch 44 and the fifth conductive branch 45, the plurality of second power chips 7 can be efficiently and uniformly arranged, instead of being connected with a same conductive portion of the conductive region, thereby avoiding the problem of increased heat due to the compact layout of the power chips and improving the heat dissipation of the module.

In some embodiments, the third conductive branch 33 and the fourth conductive branch 44 are arranged alternately along the second direction, each of the plurality of fourth conductive branches 44 is connected to a corresponding position of the second main conductive portion 31 via the second power chip 7, and each of the plurality of third conductive branches 33 is connected to a corresponding position of the fifth conductive branch 45 via the second power chip 7. Thus, the third conductive branch 33 and the fourth conductive branch 44 are arranged in the alternating arrangement, so that two adjacent second power chips 7 can be staggered in the first direction, so as to improve the heat-dissipation of the module.

In some embodiments, as shown in FIG. 8, the fourth conductive region 5 includes a fourth main conductive portion 51 and a plurality of sixth conductive branches 52 arranged along the second direction. The fourth main conductive portion 51 extends in the second direction and is configured output an alternating current signal. The sixth conductive branch 52 is connected with the fourth main conductive portion and extends towards the third conductive region 4. At least one of the plurality of the second power chips 7 is connected to the fourth main conductive portion 51 of the fourth conductive region 5, and at least one of the plurality of the second power chips 7 is connected to the sixth conductive branch 52 of the fourth conductive region 5. In this way, mutual inductance be formed within the semiconductor power module 10 when it is working so as to effectively reduce the parasitic inductance of the entire module, and the internal structural layout of the semiconductor power module 10 can be optimized so as to be conducive to improving the integration degree of the entire module. In addition, based on the layout of the sixth conductive branch 52, the plurality of second power chips 7 can be efficiently and uniformly arranged instead of being connected with a same conductive portion of the conductive region, thereby avoiding the problem of increased heat due to the compact layout of the power chips and improving the heat dissipation of the module.

In some embodiments, the fifth conductive branch 45 and the sixth conductive branch 52 are arranged alternately along the second direction. Each of the plurality of sixth conductive branches 52 is connected to the fourth conductive branch 44 at a corresponding position via the second power chip 7, and each of the plurality of fifth conductive branches 45 is connected to a corresponding position of the fourth main conductive portion 51 via the second power chip 7. Thus, the fifth conductive branch 45 and the sixth conductive branch 52 are arranged in an alternating arrangement, so that two adjacent second power chips 7 can be staggered in the first direction, so as to improve the heat-dissipation of the module.

In addition, based on the layout of the second conductive region 3, the third conductive region 4, and the fourth conductive region 5 as described above, any number of fourth conductive branch portions 44, fifth conductive branch portions 45, and sixth conductive branch portions 52 can be provided. Therefore, when the second power chips 7 are provided at the second conductive region 3, the third conductive region 4 and the fourth conductive region 5, an even number of power chips or an odd number of power chips can be suitably arranged. The power chips are no longer limited to be arranged in a symmetrical manner, and are placed in a diversified manner, the cost is low and the structure is simple.

In some embodiments, as shown in FIG. 8, at least one of the plurality of the first power chips 6 is provided in the second conductive branch 32 and is connected to the first main conductive portion 21, and at least one of the plurality of the first power chips 6 is provided in the second main conductive portion 31 and is connected to the first conductive branch 22. In this way, the internal structural layout of the semiconductor power module 10 can be optimized, and when increasing the number of the first power chips 6, the first power chips 6 can be placed correspondingly by adjusting the number of the second conductive branches 32, thereby improving the flexible application of the module and improving the integration degree of the entire module. In addition, mutual inductance can be be formed within the semiconductor power module 10 when it is working, so as to effectively reduce the parasitic inductance of the entire module.

In some embodiments, as shown in FIG. 8, at least one of the plurality of the second power chips 7 is provided in the fourth conductive branch 44 and is connected to each of the second main conductive portion 31 and the sixth conductive branch 52. At least one of the plurality of the second power chips 7 is provided in the fifth conductive branch 45 and is connected to the third conductive branch 33 and the fourth main conductive portion 51. Thus the internal structural layout of the semiconductor power module 10 can be optimized, and when increasing the number of the second power chips 7, the second power chips 7 can be placed correspondingly by adjusting the number of the fifth conductive branches 45, thereby improving the flexible application of the module and improving the integration degree of the entire module. In addition, mutual inductance can be formed within the semiconductor power module 10 when it is working, thereby effectively reducing the parasitic inductance of the entire module.

In some embodiments, the first conductive region 2 and the third conductive region 4 both have a direct current connection point for receiving a direct current signal, and the fourth conductive region has an alternating current connection point for outputting an alternating current signal. In practice, in the semiconductor power module 10, a direct current terminal can be electrically connected to a direct current connection point of the corresponding conductive region, an alternating current terminal is electrically connected to the alternating current connection point of the fourth conductive region. Therefore, through the direct current terminal and the alternating current terminal, it can realize the connection between the semiconductor power module 10 and the outside, so as to receive a direct current signal sent from the outside and output the alternating current signal to the outside, thereby realizing the function of electric energy conversion.

The setting position of each direct current connection point in the corresponding conductive region can be set according to an actual situation, such as the shape of each conductive region. For example, all direct current connection points can be set on any side of the substrate 1, or each direct current connection point can be set arbitrarily, such as respectively set in the different sides of the substrate 1, and the present application is not limited thereto. Similarly, the setting position of the alternating current connection point in the fourth conductive region can be set based on the actual situation, and there is no restriction thereon.

In some embodiments, the semiconductor power module 10 further includes a fifth conductive region 101 and a sixth conductive region 102, the fifth conductive region 101 and the sixth conductive region 102 are connected to both ends of the third conductive region 4. For example, as shown in FIG. 1 or FIG. 8, the fifth conductive region 101 and the sixth conductive region 102 are respectively connected to both ends of the third conductive region 4 to form an integrated conductive region. The fifth conductive region 101 and the sixth conductive region 102 are respectively located on both sides of the first conductive region 2 in the second direction and on both sides of the second conductive region 3 in the second direction, and are respectively spaced apart from the the first conductive region 2 and the second conductive region 3. The third conductive region 4 is configured to receive a direct current signal via the fifth conductive region 101 and the sixth conductive region 102. Thus, the fifth conductive region 101 and the sixth conductive region 102 are respectively connected to the third conductive region 4, the direct current signal can be received on the same side of the substrate 1 and can be led to the third conductive region 4 via the fifth conductive region 101 and the sixth conductive region 102. That is, the direct current signal is received on the same side of the semiconductor power module 10, which is conducive to reducing the difficulty of the subsequent process.

In some embodiments, as shown in FIG. 1, the first conductive region 2 has a first direct current connection point 11 for receiving a direct current signal on a side of the first conductive region 2 that faces away from the second conductive region 3, the fifth conductive region 101 has a second direct current connection point 12 for receiving a direct current signal on an end of the fifth conductive region 101 that is farther away from the third conductive region 4, the sixth conductive region 102 has a third direct current connection point 13 for receiving a direct current signal on an end of the sixth conductive region 102 that is further away from the third conductive region 4, and the fourth conductive region 5 has an alternating current connection point 14 on a side of the fourth conductive region 5 that faces away from the third conductive region 4. This allows the first direct current connection point 11, the second direct current connection point 12, and the third direct current connection point 13 to be located on the same side of the substrate 1, which facilitates the reduction of processing difficulty during subsequent encapsulation.

As shown in FIG. 1, the first direct current connection point 11, the second direct current connection point 12 and the third direct current connection point 13 are disposed on one side of the substrate 1 in the first direction and are arranged in the second direction, the first direct current connection point 11 is disposed between the second direct current connection point 12 and the third direct current connection point 13, and the alternating current connection point 14 is located on another side of the substrate in the first direction.

A polarity of the direct current signal connected to the second direct current connection point 12 is the same as a polarity of the direct current signal connected to the third direct current connection point 13, and is opposite to a polarity of the direct current signal connected to the first direct current connection point 11. That is, if the direct current signal connected to the third direct current connection point 13 and the direct current signal connected to the second direct current connection point 12 are anodic, the direct current signal connected to the first direct current connection point 11 is cathodic, such as shown in FIG. 1. Alternatively, if the direct current signal connected to the third direct current connection point 13 and the direct current signal connected to the second direct current connection point 12 are cathodic, the direct current signal connected to the first direct current connection point 11 is anodic.

Specifically, taking FIG. 1 as an example, in practice, the first direct current connection point 11 of the first conductive region 2 is connected to a cathode terminal, the second direct current connection point 12 of the fifth conductive region 101 is connected to a anode terminal, the third direct current connection point 13 of the sixth conductive region 102 is connected to an anode terminal, and the alternating current connection point 14 of the fourth conductive region 5 is connected to an alternating current terminal. Specifically, referring to FIG. 2, the second direct current connection point 12 and the third direct current connection point 13 are high-potential direct current terminals, the first direct current connection point 11 is a low-potential direct current terminal, the first direct current connection point 11, the second direct current connection point 12, and the third direct current connection point 13 are arranged on the same side of the substrate 1, and the alternating current connection point 14 is arranged opposite to the above mentioned three direct current connection points. As a result, after the half-bridge circuit of the semiconductor power module 10 is connected, the high-potential direct current terminals are connected to the alternating current connection point 14 to form a first bridge arm of the half-bridge circuit, and the alternating current connection point 14 is connected to the low-potential direct current terminal to form a second bridge arm of the half-bridge circuit. In this way, the mutual inductance is formed between the circuit formed by the first bridge arm and the circuit formed by the second bridge arm in the semiconductor power module 10, and the parasitic inductance of the entire module can be reduced thereby.

It is to be understood that, in practice, the direct current terminal configured to be connected to the direct current connection point and the alternating current terminal configured to be connected to the alternating current connection point are made of copper material with good electrical and thermal conductivity, so as to realize the connection between the semiconductor power module 10 and the external devices.

In some embodiments, as shown in FIG. 8, the semiconductor power module 10 further includes a seventh conductive region 103, the seventh conductive region 103 located on a side of the first conductive region 2 that faces away from the second conductive region 3 and is spaced apart from the first conductive region 2, both ends of the seventh conductive region 103 are connected to the fifth conductive region 101 and the sixth conductive region 102 respectively. As shown in FIG 8, the seventh conductive region 103, the fifth conductive region 101, the sixth conductive region 102 and the third conductive region 4 are connected to each other to form an integrated conductive region. The third conductive region 4, the fifth conductive region 101, the sixth conductive region 102 and the seventh conductive region 103 collectively surround the first conductive region 2 and the second conductive region 3.

In some embodiments, as shown in FIG. 8, the semiconductor power module 10 further includes a first small signal conductive region 8 and a first small signal input substrate 34.

The first small signal conductive region 8 is provided in the substrate 1. The first small signal input substrate 34 is provided in the second conductive region 3, and the first small signal input substrate 34 is connected to each of the first small signal conductive region 8 and the first power chip 6 to transmit a gate signal to the first power chip 6. That is, the gate signal of the first power chip 6 is separately led out from the first small signal input substrate 34 at the second conductive region 3, so that small signals in the circuit can be efficiently output so as to facilitate the control on small signals in the circuit.

Specifically, as shown in FIG. 8, a substrate can be electrically connected between the first power chips 6 that are staggered in the second conductive region 3, so as to be used as the first small signal input substrate 34, for example the substrate can be connected at the second main conductive portion 31. The first small signal input substrate 34 is electrically connected to the first small signal conductive region 8. For example, the two can be connected by means of a lead, and thereby a control end of the first power chip 6 is electrically connected to the first small signal input substrate 34, and thus the gate signal is transmitted to the first power chip 6 through the first small signal conductive region 8 and the first small signal input substrate 34, so as to achieve the purpose of controlling the first power chip 6, and to realize the output of small signals in the circuit to facilitate the subsequent control of the small signals.

In some embodiments, as shown in FIG. 8, the semiconductor power module 10 further includes a second small signal conductive region 9 and a second small signal input substrate 46.

The second small signal conductive region 9 is provided in the substrate 1. The second small signal input substrate 46 is provided in the third conductive region 4, and the second small signal input substrate 46 is connected to the second small signal conductive region 9, so as to transmit a gate signal to the second power chip 7. That is, the gate signal of the second power chip 7 is separately led out from the second small signal input substrate 46 at the third conductive region 4, so that small signals in the circuit can be efficiently output so as to facilitate the control on small signals in the circuit.

Specifically, as shown in FIG. 8, a substrate can be electrically connected between the second power chips 7 that are staggered in the third conductive region 4, so as to be used as the second small signal input substrate 46, for example the substrate can be connected at the third main conductive portion 43, The second small signal input substrate 46 is electrically connected to the second small signal conductive region 9. For example, the two can be connected by means of a lead, and thereby a control end of the second power chip 7 is electrically connected to the first small signal input substrate 34, and thus the gate signal is transmitted to the second power chip 7 through the second small signal conductive region 9 and the second small signal input substrate 46, so as to achieve the purpose of controlling the second power chip 7, and to realize the output of small signals in the circuit to facilitate the subsequent control of the small signals.

Furthermore, in an embodiment, the first small signal input substrate 34 or the second small signal input substrate 46 includes at least a conductive layer and an insulating layer. The insulating layer is electrically connected to a corresponding main conductive portion. For example, the insulating layer can be affixed to the corresponding main conductive portion via soldering or bonding, or overhangs a corresponding main conductive portion and is electrically connected to the corresponding main conductive portion. The present application is not limited to any of these examples. When the position of the first small signal input substrate 34 or the second small signal output substrate 46 is set, the insulating layer of the first small signal input substrate 34 or the second small signal input substrate 46 is electrically connected to a corresponding main conductive portion, and the conductive layer of the first small signal input substrate 34 or the second small signal input substrate 46 is electrically connected to a corresponding small signal conductive region.

In an embodiment, the positions of the first small signal conductive region 8 and the second small signal conductive region 9 on the substrate 1 can be set according to the actual situation, and there is no restriction thereon. For example, as shown in FIG. 8, the first small signal conductive region 8 extending along the first direction of the substrate 1 and the second small signal conductive region 9 extending along the first direction of the substrate 1 are located on both sides of the fourth conductive region 5 in the second direction. Alternatively, the first small signal conductive region 8 is disposed on one side of the second conductive region 3 so as to be connected to the first small signal input substrate 34, and the second small signal conductive region 9 is disposed on one side of the third conductive region 4 so as to be connected to the second small signal input substrate 46.

In some embodiments, the semiconductor power module 10 further includes an insulating cover that is mounted on the substrate 1 and that covers the first conductive region 2, the second conductive region 3, the third conductive region 4, the fourth conductive region 5, the at least one first power chip 6 and the at least one second power chip 7 to insulate and protect elements therein.

In conclusion, the semiconductor power module 10 according to the present disclosure has the advantages of high integration, good heat-dissipation performance, and simple structure.

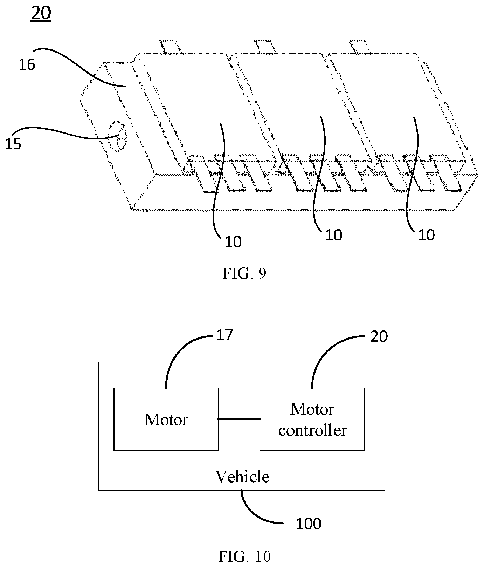

According to an embodiment of the second aspect of the present disclosure, a motor controller is provided. As shown in FIG. 9, the motor controller 20 includes a heat-dissipating base plate 16, a cooling liquid channel 15 and the semiconductor power module 10 provided in the any of the above embodiments.

The heat-dissipating base plate 16 is mounted to the cooling liquid channel 15. The at least one semiconductor power module 10 is disposed on the heat-dissipating base plate 16.

For example, as shown in FIG. 9, three semiconductor power modules 10 arranged in parallel are arranged in a linear pattern, and the heat-dissipating base plate 18 is welded to the bottom of the semiconductor power module 10. The cooling liquid channel 15 such as a water channel is provided with slots, and the heat-dissipation base plate 16 is mounted on the slots of the cooling liquid channel 15, so as to have a heat dissipation function on the semiconductor power module 10, In this way, the motor controller is simple in design, is easy to realize, and is convenient to operate.

In an embodiment, the semiconductor power module 10 based on the above embodiment has a uniform structural layout and good heat-dissipation, and the motor controller 20 can be applied to the application of various cooling liquid channels, such as series cooling liquid channels or parallel cooling liquid channels, which can improve the flexibility of the application of the motor controller 20, and reduce the stray inductance in the circuit during the application.

The motor controller 20 according to the present disclosure, by adopting the semiconductor power module 10 that is provided in the above embodiment and that is disposed on the heat-dissipation base plate 16, the stray inductance in the circuit can be effectively reduced and the heat-dissipation is good.

According to an embodiment of a third aspect of the present disclosure, a vehicle is provided. As shown in FIG. 10, the vehicle 100 includes a motor 17 and a motor controller 20 provided in the above embodiment. The the semiconductor power module 10 of the motor controller 20 is connected to the motor 17.

According to the vehicle 100 of the present disclosure, by using the motor controller 20 provided in the above embodiment, the inductance can be reduced and heat-dissipation can be improved.

In the illustration of this description, an illustration with reference to the terms "one embodiment", "some embodiments", "illustrative embodiments", "an example", "a particular example" or "some examples" and so on mean that a particular feature, structure, material, or characteristic described in connection with the embodiment(s) or example(s) is included in at least one embodiment or example of the present disclosure. In this description, the exemplary expressions of the above terms do not necessarily specify the same embodiments or examples.

Although embodiments of the present disclosure have been shown and described, it will be understood by those skilled in the art that various changes, modifications, alternations and modifications may be made to these embodiments without departing from the principles and spirit of the present disclosure, the scope of which is defined by the claims and their equivalents.

## Claims

1. A semiconductor power module, comprising:
A substrate having a first direction and a second direction that are orthogonal to each other;
a first conductive region, a second conductive region, a third conductive region, and a fourth conductive disposed on the substrate that are spaced apart from each other, and that are arranged in sequence along the first direction of the substrate, wherein each of the first conductive region, the second conductive region, the third conductive region, and the fourth conductive region extends along the second direction of the substrate, the first conductive region and the third conductive region are configured to transmit a direct current signal, and the fourth conductive region is configured to transmit an alternating current signal; and
at least one first power chip and at least one second power chip, the first power chip is electrically connected to each of the first conductive region and the second conductive region, the second power chip is electrically connected to each of the second conductive region, the third conductive region and the fourth conductive region.

2. The semiconductor power module according to claim 1, wherein the first conductive region and the third conductive region are configured to receive the direct current signal, and the fourth conductive region is configured to output the alternating current signal.

3. The semiconductor power module according to claim 1 or 2, further comprising:
a fifth conductive region and a sixth conductive region that are respectively connected to both ends of the third conductive region, the fifth conductive region and the sixth conductive region are respectively located on both sides of the first conductive region in the second direction and on both sides of the second conductive region in the second direction, and the fifth conductive region and the sixth conductive region respectively spaced apart from the first conductive region and the second conductive region;
wherein the third conductive region configured to receive the direct current signal via the fifth conductive region and the sixth conductive region.

4. The semiconductor power module according to any of claims 1 to 3, further comprising:
a seventh conductive region located on a side of the first conductive region that faces away from the second conductive region, wherein the seventh conductive region is spaced apart from the first conductive region, both ends of the seventh conductive region are connected to the fifth conductive region and the sixth conductive region respectively, the third conductive region, the fifth conductive region, the sixth conductive region, and the seventh conductive region collectively surrounds the first conductive region and the second conductive region.

5. The semiconductor power module according to any of claims 1 to 4, wherein the first power chip and the second power chip are arranged along the first direction.

6. The semiconductor power module according to any of claims 1 to 5, wherein a plurality of first power chips are comprised, the plurality of the first power chips are arranged along the second direction, and two first power chips that are disposed adjacent to each other are staggered in the first direction; and
a plurality of second power chips are comprised, the plurality of the second power chips are arranged along the second direction, and two second power chips that are disposed adjacent to each other are staggered in the first direction.

7. The semiconductor power module according to any of claims 1 to 6, wherein the first power chip is provided in the second conductive region, and the second power chip is provided in the third conductive region.

8. The semiconductor power module according to any of claims 1 to 7, wherein the first conductive region comprises:
a first main conductive portion extending in the second direction and configured to receive the direct current signal; and
a plurality of first conductive branches arranged along the second direction, wherein the first conductive branch is connected with the first main conductive portion and extends towards the second conductive region in the first direction;
wherein a plurality of first power chips are comprised, at least one of the plurality of the first power chips is connected to the first main conductive portion of the first conductive region, and at least one of the plurality of the first power chips is connected to the first conductive branch of the first conductive region.

9. The semiconductor power module according to any of claims 1 to 8, wherein the second conductive region comprises:
a second main conductive portion extending in the second direction;
a plurality of second conductive branches arranged along the second direction, wherein the second conductive branch is connected with the second main conductive portion and extends towards the first conductive region in the first direction; and
a plurality of third conductive branches arranged along the second direction, wherein the third conductive branch is connected with the second main conductive portion and extends towards the third conductive region in the first direction;
wherein at least one of the plurality of the first power chips is connected to the second main conductive portion of the second conductive region, and at least one of the plurality of the first power chips is connected to the second conductive branch of the second conductive region, a plurality of second power chips are included, at least one of the plurality of the second power chips is connected to the second main conductive portion of the second conductive region, and at least one of the plurality of the second power chips is connected to the third conductive branch of the second conductive region.

10. The semiconductor power module according to any of claims 1 to 9, wherein the first conductive branch and the second conductive branch are arranged alternately along the second direction;
each of the plurality of first conductive branches is connected to a corresponding position of the second main conductive portion via the first power chip, and each of the plurality of second conductive branches is connected to a corresponding position of the first main conductive portion via the first power chip.

11. The semiconductor power module according to any of claims 1 to 10, wherein the third conductive region comprises:
a third main conductive portion extending in the second direction and configured to receive the direct current signal;
a plurality of fourth conductive branches arranged in the second direction, wherein the fourth conductive branch is connected with the third main conductive portion and extends towards the second conductive region in the first direction; and
a plurality of fifth conductive branches arranged in the second direction, wherein the fifth conductive branch is connected with the third main conductive portion and extends towards the fourth conductive region in the first direction;
wherein at least one of the plurality of the second power chips is connected to the fourth conductive branch of the third conductive region, and at least one of the plurality of the second power chips is connected to the fifth conductive branch of the third conductive region.

12. The semiconductor power module according to any of claims 1 to 11, wherein the third conductive branch and the fourth conductive branch are arranged alternately along the second direction;
each of the plurality of fourth conductive branches is connected to a corresponding position of the second main conductive portion via the second power chip, and each of the plurality of third conductive branch is connected to a corresponding position of the fifth conductive branch via the second power chip.

13. The semiconductor power module according to any of claims 1 to 12, wherein the fourth conductive region comprises:
a fourth main conductive portion extending in the second direction and configured to output the alternating current signal; and
a plurality of sixth conductive branches arranged along the second direction, wherein the sixth conductive branch is connected with the fourth main conductive portion and extends towards the third conductive region;
wherein at least one of the plurality of the second power chips is connected to the fourth main conductive portion of the fourth conductive region, and at least one of the plurality of the second power chips is connected to the sixth conductive branch of the fourth conductive region.

14. The semiconductor power module according to any of claims 1 to 13, wherein the fifth conductive branch and the sixth conductive branch are arranged alternately along the second direction;
each of the plurality of sixth conductive branches is connected to a corresponding position of the fourth conductive branch via the second power chip, and each of the plurality of fifth conductive branches is connected to a corresponding position of the fourth main conductive portion via the second power chip.

15. The semiconductor power module according to any of claims 1 to 14, wherein at least one of the plurality of the first power chips is provided in the second conductive branch, at least one of the plurality of the first power chips is connected to the first main conductive portion, and at least one of the plurality of the first power chips is provided in the second main conductive portion, and at least one of the plurality of the first power chips is connected to the first conductive branch.

16. The semiconductor power module according to any of claims 1 to 15, wherein at least one of the plurality of the second power chips is provided in the fourth conductive branch, at least one of the plurality of the second power chips is connected to the second main conductive portion, at least one of the plurality of the second power chips is connected to the sixth conductive branch, and at least one of the plurality of the second power chips is provided in the fifth conductive branch, at least one of the plurality of the second power chips is connected to the third conductive branch, at least one of the plurality of the second power chips is connected to the fourth main conductive portion.

17. The semiconductor power module according to any of claims 1 to 16, wherein the first conductive region has a first direct current connection point for receiving the direct current signal on a side of the first conductive region that faces away from the second conductive region, the fifth conductive region has a second direct current connection point for receiving the direct current signal on an end of the fifth conductive region that is further away from the third conductive region, the sixth conductive region has a third direct current connection point for receiving the direct current signal on an end of the sixth conductive region that that is further away from the third conductive region, and the fourth conductive region has an alternating current connection point on a side of the fourth conductive region that faces away from the third conductive region; and
wherein the first direct current connection point, the second direct current connection point, and the third direct current connection point are disposed on one side of the substrate in the first direction and are arranged in the second direction, the first direct current connection point is disposed between the second direct current connection point and the third direct current connection point, a polarity of the direct current signal connected to the second direct current connection point is the same as a polarity of the direct current signal connected to the third direct current connection point, a polarity of the direct current signal connected to the third direct current connection point is opposite to a polarity of the direct current signal connected to the first direct current connection point, and the alternating current connection point is located on another side of the substrate in the first direction.

18. The semiconductor power module according to any of claims 1 to 17, further compirsing:
a first small signal conductive region provided in the substrate; and
a first small signal input substrate provided in the second conductive region, wherein the first small signal input substrate is connected to each of the first small signal conductive region and the first power chip to transmit a gate signal to the first power chip.

19. The semiconductor power module according to any of claims 1 to 18, further compirsing:
a second small signal conductive region provided in the substrate; and
a second small signal input substrate provided in the third conductive region, wherein the second small signal input substrate is connected to each of the second small signal conductive region and the second power chip to transmit a gate signal to the second power chip.

20. The semiconductor power module according to any of claims 1 to 19, further comprising:
an insulating cover mounted on the substrate and covering the first conductive region, the second conductive region, the third conductive region, the fourth conductive region, the at least one first power chip, and the at least one second power chip.

21. A motor controller comprising:
a heat-dissipating base plate and a cooling liquid channel, the heat-dissipating base plate mounted to the cooling liquid channel; and
the semiconductor power module according to any one of claims 1-20, wherein the semiconductor power module is disposed on the heat-dissipating base plate.

22. A vehicle comprising:
a motor; and
the motor controller according to claim 21,wherein the motor controller is connected to the motor.
